Europäisches Patentamt

European Patent Office

Office européen des brevets

(19)

(11) EP 1 517 186 A1

(12) **EUROPEAN PATENT APPLICATION**

(43) Date of publication:
23.03.2005 Bulletin 2005/12

(51) Int Cl.⁷: $G03F\ 7/20$

(21) Application number: 04077538.9

(22) Date of filing: 14.09.2004

(84) Designated Contracting States:
AT BE BG CH CY CZ DE DK EE ES FI FR GB GR
HU IE IT LI LU MC NL PL PT RO SE SI SK TR
Designated Extension States:
AL HR LT LV MK

(30) Priority: 18.09.2003 EP 03077957

(71) Applicant: ASML Netherlands B.V.
5504 DR Veldhoven (NL)

(72) Inventors:
• Moors, Johannes Hubertus Josephina
5709 MT Helmond (NL)
• Banine, Vadim Yevgenyevich
5704 NK Helmond (NL)

(74) Representative:
Winckels, Johannes Hubertus F. et al
Vereenigde
Nieuwe Parklaan 97
2587 BN Den Haag (NL)

(54) **Lithographic apparatus and device manufacturing method**

(57)    A lithographic apparatus comprising a radiation system (IL) for providing a projection beam of radiation; a support structure (MT) for supporting patterning means (MA), the patterning means serving to impart the projection beam with a pattern in its cross-section; a substrate table (WT) for holding a substrate (W); and a projection system (PL) for projecting the patterned beam onto a target portion of the substrate. According to the invention the apparatus further comprises a source (IRS) for providing infrared radiation into a measurement zone (1) within said lithographic apparatus, and a detector (2) for receiving the infrared radiation from the source after having passed through said measurement zone and for outputting a signal indicative of the presence of a gas present within the measurement zone.

Fig. 2

EP 1 517 186 A1

**Description**

The present invention relates to a lithographic apparatus and a device manufacturing method.

A lithographic apparatus is a machine that applies a desired pattern onto a target portion of a substrate. Lithographic apparatus can be used, for example, in the manufacture of integrated circuits (ICs). In that circumstance, a patterning means, such as a mask, may be used to generate a circuit pattern corresponding to an individual layer of the IC, and this pattern can be imaged onto a target portion (e.g. comprising part of, one or several dies) on a substrate (e.g. a silicon wafer) that has a layer of radiation-sensitive material (resist). In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

To reduce the size of features that can be imaged using a lithographic apparatus, it is desirable to reduce the wavelength of the illumination radiation. Ultraviolet wavelengths of less than 180nm are therefore currently used, for example 157nm or 126 nm. Also used are extreme ultraviolet (EUV) wavelengths of less than 50nm, for example 13.5nm.

Whilst gaseous contamination particles in lithographic apparatuses continue to be a problem, it has been found that apparatuses operating at shorter wavelengths, such as those less than 180nm, are significantly more sensitive to the presence of contaminant particles than those operating at longer wavelengths. Contaminant particles such as hydrocarbon molecules and water vapour may be introduced into the apparatus from external sources, for example, gas supplies, wafers or masks, or they may be generated within the lithographic apparatus itself, for example by degassing of equipment.

It has been found that contaminant particles tend to adsorb to the optical components in the apparatus and cause a loss in transmission of the radiation beam. When using 157nm or EUV radiation, a loss in transmission of about 1% is observed when only one or a few monolayers of contaminant particles form on the optical surfaces. Such a loss in transmission is unacceptably high. Further, the uniformity requirement of the projection beam intensity for such apparatuses is less than 0.2%. Contamination compromises this requirement.

There is also a risk that the adsorption of contaminant particles on the surface of the optical components, or within the optical surface in the case of a porous surface, for example, an anti reflection coating, may cause damage to these optical components. Damage can occur if the optical components are suddenly irradiated with UV radiation, for example 157nm at a high power. The irradiation causes rapid evaporation of the smaller contaminant particles, such as water molecules, which may be trapped within the porous surface of an optical component, causing damage to the optical component itself. Such damage requires costly repair or replacement of components. Further, adsorption of contaminants to optical components such as reflectors and lenses (in lithographic apparatuses operating a longer wavelengths) has been found to reduce the operating lifetime of such components. Further, cracking of molecules reduces the operating lifetime of components. For example during EUV exposure hydrocarbons are cracked to generate carbon which leads to build up of carbon layers on optical elements.

It is therefore desired that any gases, including contaminant gases, in a lithographic apparatus are monitored.

Previously, it has been proposed to monitor gases in lithographic apparatuses using a known technique called residual gas analysis (RGA). A residual gas monitor is a mass spectrometer which first creates, then analyses charged particles (ions) using either magnetic or electric fields to separate the ions of different masses. However, it has been found that RGA suffers drawbacks. The residual gas monitor generates heat, such thermal disturbances in the apparatus lead to imaging errors. Also, it is a necessary requirement of RGA that the analysis must be implemented *in situ*, that is in the volume in which the contaminants are originally found. Also, the measurements require a certain amount of time to complete, and are thus, quite time consuming.

A further problem with RGA is that it cannot be exposed to high pressures. This limits the dynamical range of the RGA.

Yet, another problem is that because RGA analyses ions, and not complete molecules, the analysis is difficult to interpret. A further drawback of the ionisation process in RGA is that larger molecules are broken up. This drawback is a particular problem because it is desirable in lithographic apparatuses, especially those operating at wavelengths shorter than 157nm where contamination is a major concern, to identify the precise molecular structure of the contaminants in order to be able to identify their origin, and to be able to gain further insight into the contamination process, which at present is not fully understood. One consequence of having to break up larger molecules in RGA is that extensive calibration of the RGA apparatus is required. The degree of ionisation depends on the molecule and the RGA apparatus setting. To achieve accurate measurements of pressure, these have to be calibrated. However, molecules are broken up to ions before they can be identified and measured. Thus, adding complexity to the calibration of the RGA apparatus.

It is an object of the present invention to address the problems encountered with detecting gases in a lithographic apparatus. In particular, it is an object of the present invention to provide a lithographic apparatus in which gaseous contaminants are detected and identified in a fast and non-destructive manner.

According to an aspect of the invention, there is provided a lithographic apparatus comprising:

- an illumination system for providing a projection beam of radiation;
- a support structure for supporting patterning means, the patterning means serving to impart the projection beam with a pattern in its cross-section;
- a substrate table for holding a substrate; and
- a projection system for projecting the patterned beam onto a target portion of the substrate, characterized in that the apparatus further comprises a source for providing infrared radiation into a measurement zone within the lithographic apparatus, and a detector for receiving the infrared radiation from the source after having passed through the measurement zone and for outputting a signal indicative of the presence of a gas present within said measurement zone. By using infrared radiation and a detector in the lithographic apparatus, the presence of gases can be detected a non-destructive way. Further, their presence is found in a non-intrusive, continuous manner. Further, identification of contaminants follows in a fast manner without complex interpretation of the results being necessary, since a single signal can be produced which may be provided as part of a time resolved spectrum, wherein each component of the spectrum corresponds to a particular gas. Further, the invention has application over a wide dynamic range, and the detected signals do not suffer noise due to cross talk between different gases.

In a preferred embodiment, the source comprises a tunable infrared source, tuned so that the wavelength of the radiation output by the infrared source corresponds to the wavelength absorbed by at least one of a predetermined gas or gases. By tuning the source to output a wavelength of a predetermined gas, the detection is designed to be highly selective and accurate in its identification of gases.

In a preferred embodiment, the source comprises a plurality of the tunable infrared sources, respectively tuned to a plurality of wavelengths corresponding to a plurality of predetermined gases. By providing a plurality of infrared sources tuned to a plurality of predetermined wavelengths corresponding to known gases, a time resolved spectrum is produced in which the presence of all the predetermined contaminants is provided. In this way the application of the infrared absorption apparatus can be adapted to the very specific conditions found in a lithographic apparatus and other apparatuses where highly selective and accurate identification is required.

In a preferred embodiment, the measurement zone is provided with at least one optical element which is disposed for causing said infrared radiation to follow a path having a path length longer than one of the dimensions of the measurement zone. By providing a path length longer than a dimension of the measurement zone along which the infrared radiation passes, a more accurate assessment of the presence of a particular gas is made, since the path length is proportional to the adsorption of radiation by a particular gas. Thus, the longer the path length the greater the absorption, and the greater the difference between a test radiation beam and a control radiation beam and the higher the sensitivity will be.

In a preferred embodiment, the detector is arranged to detect the presence of a gas or gases in the projection system. By detecting the presence of a gas in the projection system, the conditions within which the highly expensive optical elements operate can be closely monitored.

In a preferred embodiment, a control circuit is provided, responsive to the detector, arranged so that if a measured partial pressure of the gas or at least one of the gases exceeds a predetermined threshold, the control circuit generates a control signal to prevent the illumination system from providing said projection beam of radiation. In this way, if a threshold partial pressure of a potentially damaging gas is measured damage to the projection system is avoided.

In a preferred embodiment, the optical element or elements disposed in the measurement zone is or are comprised in the projection system. In this way, convenient incorporation of the measuring zone is achieved, since existing structures (in particular mirrors) in the projection system are used. Further, the infrared radiation may be introduced into the projection system using existing structures provided in the supporting frame of the projection system, such as holes provided to allow the projection beam to enter, or holes provided in the supporting frame through which certain systems are evacuated. Thus, the incorporation of the infrared source, measurement zone and detector is both easy to facilitate and does not compromise the structural integrity of the supporting frame of the projection system, which must be both thermally and mechanically stable.

In a preferred embodiment, the lithographic apparatus comprises a substrate handling apparatus for supplying a substrate to said substrate table, wherein the detector is arranged to detect the presence of a gas or gases in the substrate handling apparatus. It has been found that the substrate handling apparatus is a major source of gases, in particular contaminating gases, in the lithographic apparatus. Thus, by identifying the presence of gases in the substrate handling apparatus, a major source of contaminants is monitored.

In a preferred embodiment, a control circuit, responsive to the detector is arranged so that if a measured partial pressure of a gas or at least one of the gases exceeds a predetermined threshold, the control circuit generates a control signal to prevent the substrate handling apparatus from supplying a substrate to the substrate table. By preventing the substrate handling apparatus from supplying a substrate to the substrate table when the partial pressure of a gas exceeds a threshold level, the amount of, in particular contaminating, gases introduced to the projection system is prevented.

In a preferred embodiment, the detector is arranged to measure the partial pressure/s of a contaminant gas or contaminant gases in the lithographic apparatus. By measuring the partial pressure of contaminating gases, the level of contamination can be assessed to avoid damage to the lithographic apparatus.

According to a further aspect of the invention, there is provided a device manufacturing method comprising the steps of:

- providing a substrate;
- providing a projection beam of radiation using an illumination system;
- using patterning means to impart the projection beam with a pattern in its cross-section; and
- projecting the patterned beam of radiation onto a target portion of the substrate,

characterized by providing infrared radiation into a measurement zone within said lithographic apparatus; receiving said infrared radiation after said infrared radiation has passed through said measurement zone; and outputting a signal indicative of the presence of a gas present within said measurement zone.

According to a further aspect of the present invention, there is provided an infrared source for use in an infrared absorption apparatus for a lithographic apparatus, the source comprising a tunable infrared source, tuned so that the wavelength of the radiation output by the infrared source corresponds to the wavelength absorbed by at least one of a predetermined or likely predetermined gas or gases. In a preferred embodiment, the infrared source comprises a plurality of the tunable infrared sources, tuned to a plurality of wavelengths corresponding to a plurality of predetermined or likely predetermined gases. By providing tunable sources, a highly selective infrared absorption apparatus is provided which may be designed to meet the requirements of any particular application. It will be understood that although hereinbelow the application of the infrared source in a lithographic apparatus is described in detail, the infrared source of the present invention is not limited to this particular application, but has application to other apparatuses. For example, to apparatuses where a highly selective source for accurate identification of gases known from a predetermined range of gases is required.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm) and extreme ultra-violet (EUV) radiation (e.g. having a wavelength in the range of 5-20 nm), as well as particle beams, such as ion beams or electron beams.

The term "patterning means" used herein should be broadly interpreted as referring to means that can be used to impart a projection beam with a pattern in its cross-section such as to create a pattern in a target portion of the substrate. It should be noted that the pattern imparted to the projection beam may not exactly correspond to the desired pattern in the target portion of the substrate. Generally, the pattern imparted to the projection beam will correspond to a particular functional layer in a device being created in the target portion, such as an integrated circuit.

Patterning means may be transmissive or reflective. Examples of patterning means include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned. In each example of patterning means, the support structure may be a frame or table, for example, which may be fixed or movable as required and which may ensure that the patterning means is at a desired position, for example with respect to the projection system. Any use of the terms "reticle" or "mask" herein may be considered synonymous with the more general term "patterning means".

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables (and/ or two or more mask tables). In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the mask and the first element of the projection system. Immersion techniques are well known in the art for increasing the numerical aperture of projection systems.

Embodiments of the invention will now be described, by way of example only, with reference to the accompanying schematic drawings in which corresponding reference symbols indicate corresponding parts, and in which:

- Figure 1 depicts a lithographic apparatus according to an embodiment of the invention;
- Figure 2 depicts details of a lithographic apparatus including an infrared absorption apparatus according to an embodiment of the present invention;
- Figure 3 depicts details of a lithographic apparatus including an infrared absorption apparatus according to a further embodiment of the present invention;
- Figure 4a depicts a plot of infrared intensity against wavelength of a calibration signal for use in the detection according to an embodiment of the present invention;
- Figure 4b depicts a plot of infrared intensity against wavelength of a detected signal detected by a detector according to an embodiment of the present invention;
- Figure 5 depicts details of an infrared source according to an embodiment of the present invention; and
- Figure 6 depicts details of an infrared detector according to an embodiment of the present invention.

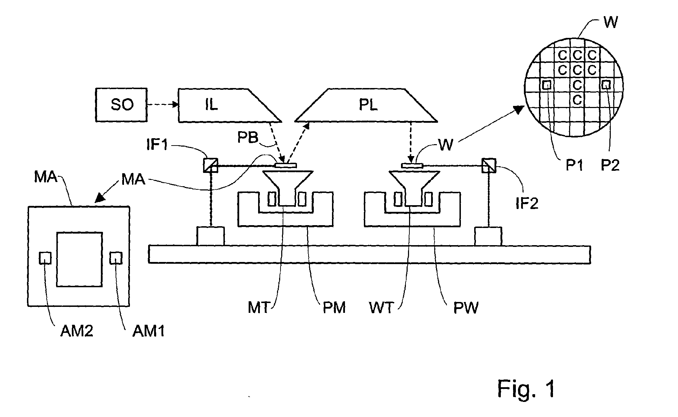

Figure 1 schematically depicts a lithographic apparatus according to a particular embodiment of the invention. The apparatus comprises:

- an illumination system (illuminator) IL for providing a projection beam PB of radiation (e.g. UV or EUV radiation).
- a first support structure (e.g. a mask table) MT for supporting patterning means (e.g. a mask) MA and connected to first positioning means PM for accurately positioning the patterning means with respect to item PL;
- a substrate table (e.g. a wafer table) WT for holding a substrate (e.g. a resist-coated wafer) W and connected to second positioning means PW for accurately positioning the substrate with respect to item PL; and
- a projection system (e.g. a reflective projection lens) PL for imaging a pattern imparted to the projection beam PB by patterning means MA onto a target portion C (e.g. comprising one or more dies) of the substrate W.

As here depicted, the apparatus is of a reflective type (e.g. employing a reflective mask or a programmable mirror array of a type as referred to above). Alternatively, the apparatus may be of a transmissive type (e.g. employing a transmissive mask).

The illuminator IL receives a beam of radiation from a radiation source SO. The source and the lithographic apparatus may be separate entities, for example when the source is a plasma discharge source. In such cases, the source is not considered to form part of the lithographic apparatus and the radiation beam is generally passed from the source SO to the illuminator IL with the aid of a radiation collector comprising for example suitable collecting mirrors and/or a spectral purity filter. In other cases the source may be integral part of the apparatus, for example when the source is a mercury lamp. The source SO and the illuminator IL, may be referred to as a radiation system.

The illuminator IL may comprise adjusting means for adjusting the angular intensity distribution of the beam. Generally, at least the outer and/or inner radial extent (commonly referred to as σ-outer and σ-inner, respectively) of the intensity distribution in a pupil plane of the illuminator can be adjusted. The illuminator provides a conditioned beam of radiation, referred to as the projection beam PB, having a desired uniformity and intensity distribution in its cross-section.

The projection beam PB is incident on the mask MA, which is held on the mask table MT. Being reflected by the mask MA, the projection beam PB passes through the lens PL, which focuses the beam onto a target portion C of the substrate W. With the aid of the second positioning means PW and position sensor IF2 (e.g. an interferometric device), the substrate table WT can be moved accurately, e.g. so as to position different target portions C in the path of the beam PB. Similarly, the first positioning means PM and position sensor IF 1 can be used to accurately position the mask MA with respect to the path of the beam PB, e.g. after mechanical retrieval from a mask library, or during a scan. In general, movement of the object tables MT and WT will be realized with the aid of a long-stroke module (coarse positioning) and a short-stroke module (fine positioning), which form part of the positioning means PM and PW. However, in the case of a stepper (as opposed to a scanner) the mask table MT may be connected to a short stroke actuator only, or may be fixed. Mask MA and substrate W may be aligned using mask alignment marks AM1, AM2 and substrate alignment marks P1, P2.

The depicted apparatus can be used in the following preferred modes:

1. In step mode, the mask table MT and the substrate table WT are kept essentially stationary, while an entire pattern imparted to the projection beam is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.

2. In scan mode, the mask table MT and the substrate table WT are scanned synchronously while a pattern imparted to the projection beam is projected onto a target portion C (i.e. a single dynamic exposure). The velocity and direction of the substrate table WT relative to the mask table MT is determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.

3. In another mode, the mask table MT is kept essentially stationary holding a programmable patterning means, and the substrate table WT is moved or scanned while a pattern imparted to the projection beam is projected onto a target portion C. In this mode, generally a pulsed radiation source is employed and the programmable patterning means is updated as required after each movement of the substrate table WT or in between successive radiation pulses during a scan. This mode of operation can be readily applied to maskless lithography that utilizes programmable patterning means, such as a programmable mirror array of a type as referred to above.

Combinations and/or variations on the above described modes of use or entirely different modes of use may also be employed.

In specific embodiments of the present invention, infrared radiation is used to identify the presence of a gas in the projection system and the substrate handling apparatus. However, the present invention may be used to identify the presence in other components of the apparatus. The present invention may be applied simultaneously at different locations within the apparatus. In such cases, the data processing, discussed hereinbelow, may be carried out locally at each location within the apparatus or centrally within or remote from the apparatus. In a particular embodiment, the present invention identifies the presence of a contaminating gas in the lithographic apparatus. However, the invention is not limited in this respect and the radiation may be used to detect the presence of other gases which may be introduced for a particular reason into the lithographic apparatus. One further advantage of using infrared radiation to detect the presence of a gas in a lithographic apparatus is that infrared radiation is not absorbed or scattered by nitrogen gas, which is used to purge certain lithographic apparatuses. In such apparatuses it is not necessary to detect the presence of nitrogen. Thus, the signal output by the detector achieved using the present invention does not suffer any background noise due to the detection of purging nitrogen. This allows detection of other gases, in particular contaminating gases, to be carried out more accurately.

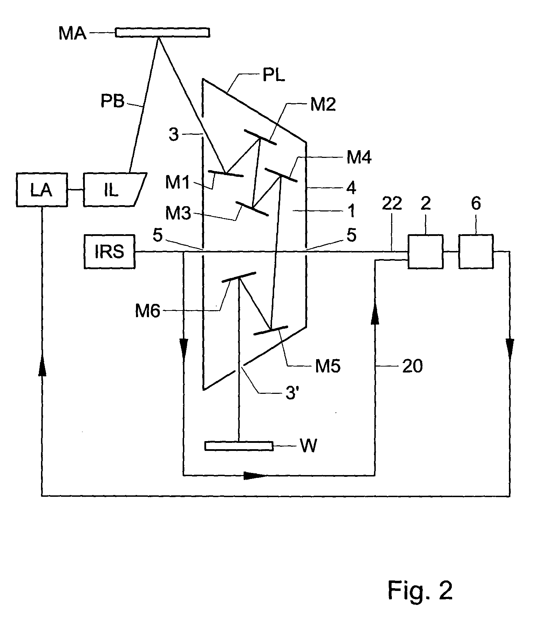

Figure 2 depicts details of a lithographic apparatus including an infrared absorption apparatus according to an embodiment of the present invention. For those elements having the same reference numeral as elements shown and described with reference to figure 1, figure 1 is referred to. The projection system PL typically comprises a supporting frame 4 on which a plurality of optical elements, typically mirrors M1-M6, are disposed. The projection beam PB enters the projection system PL via an opening 3 formed in the supporting frame 4 and follows a path defined by mirrors M1-M6 before leaving the projection system PL via opening 3'. In the embodiment depicted in figure 2, an infrared absorption apparatus IRS, 2, 6 is provided. The principles of infrared gas absorption analysis are, as such, well known, and are described for example in US-3 939 348, incorporated herein by reference. In particular, the bonds within any molecule rotate and vibrate at specific frequencies. Generally vibrational frequencies lie in the infrared region. Therefore, by irradiating molecules with infrared radiation, those molecules having a vibrational frequency corresponding to the wavelength of the radiation will absorb photons. As a result the transmitted intensity of the radiation passed through a measurement zone 1, 100 will be less. The greater the concentration or partial pressure of the molecule in the measurement zone, the greater the absorption. Thus, by measuring the amount of absorption, the partial pressure of the absorbing molecule can be established. Therefore, using infrared absorption the presence of molecules can be detected, and their partial pressure determined. In particular, according to an embodiment of the present invention, the infrared wavelength emitted or detected can be tuned such that a vibrational-rotational transition in certain molecules is excited. For example, the C-C bond in a hydrocarbon molecule.

The infrared source IRS may be a broadband emitter which provides radiation of a range of wavelengths, or may provide radiation of a single, or a narrower range of wavelengths. Preferably, the source is adjustable so that it can be tuned to different wavelengths. Filters may also be used to select desired wavelengths. Typical sources include a solid state diode, which may be tunable, a hot object, for example a band lamp, a laser, for example a helium neon (HeNe) laser. In order to reduce any thermal load on the system in which the analysis takes place, the source may be disposed behind a pin hole (not shown). Suitable wavelengths or ranges of wavelengths for the infrared radiation fall within the range $0.3cm^{-1}$ to $4600cm^{-1}$, typically from 400 to $4600cm^{-1}$. In one embodiment, a contaminant molecule is identified and its partial pressure is measured by irradiating it with infrared radiation characteristic of the vibrational frequency of that molecule, or of a bond within that molecule. For example, when considering vibrational excitation, an alkyl C-H bond has a stretching frequency in the range $2800cm^{-1}$ to $300cm^{-1}$ and an O-H bond has a stretching frequency in the range $2800cm^{-1}$ to $3800cm^{-1}$. The precise frequency of each vibration in any given molecule will be determined by a number of factors such as steric influences and non-covalent bonding, such as hydrogen bonding. The predominant factor contributing to the precise frequency is the molecular structure of the particular molecule. Approximate frequencies for a variety of chemical bonds are given in the table below:

Table 1

| Vibration | Frequency ($cm^{-1}$) |
|-----------|----------------------|
| O-H | 2800-3800 |
| O-H (Si-OH) | 3800 |
| OH (Si-OH) | 4600 |
| C-H | 2960 |
| C-C | 900 |
| C=C | 1650 |
| C=O | 1700 |
| S=O | 1310 |
| C-F | 650 |
| Si-Si | 430 |

Infrared radiation of one of the above specific frequencies or a range of frequencies including one of the above frequencies can therefore be used to excite a molecule containing the corresponding type of bond. Whilst Table 1 gives a list of absorbed frequencies, the present invention also may be used to detect scattered frequencies of infrared radiation. The frequencies of scattered radiation will differ from the absorbed frequencies discussed above, but may also be used in the same way to detect a particular gas.

Many of the contaminant molecules present in a lithographic apparatus contain O-H bonds, for example water and alcohols, and therefore a suitable range of frequencies is from $2800cm^{-1}$ to $3800cm^{-1}$. The vibration frequency of water is at the upper end of this range, so to identify the presence and measure the partial pressure of water vapour frequency of $3500cm^{-1}$ to $3800cm^{-1}$ can be used. Similarly, other contaminants can be identified, and their partial pressures measured by providing radiation having a frequency which corresponds to a vibration frequency of the relevant contaminant. Several frequencies may be irradiated in turn or simultaneously, such that several different contaminants are identified and analyzed either in series or parallel.

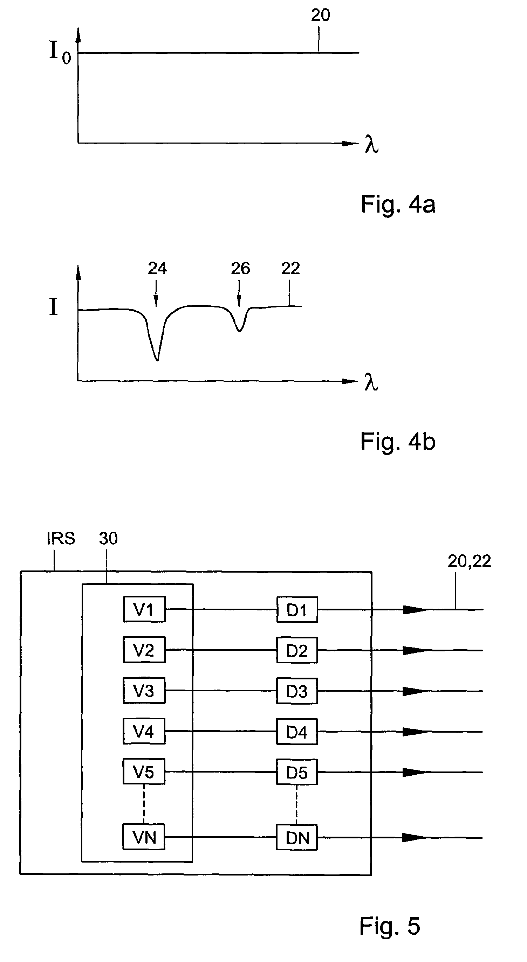

The infrared absorption apparatus IRS, 1, 2, 100 may be incorporated in the lithographic apparatus as shown in figure 1 as shown in figure 2. In one embodiment windows 5 are provided in the supporting frame 4 through which the infrared radiation passes into measuring zone 1. The windows may be formed especially for this purpose, however alternatively, existing holes or windows in the supporting frame 4 may be used. In one embodiment openings 3,3' may also be used to introduce infrared radiation into the measuring zone 1. In such an embodiment, the mirrors M1-M6 are used to reflect the infrared radiation. This particular, arrangement is advantageous, since it increases the path length of the IR radiation, the significance of which is described hereinbelow with respect to figures 4a and 4b. Alternatively, the provision of additional optical elements in the measurement zone 1, 100 is also envisaged in order to increase the path length of the radiation through the measurement zone 1, 100. In the particular embodiment shown in figure 2, the infrared source IRS is seen to be aligned with a detector 2. However, this is not essential. Neither is it essential that the IR source has any particular directionality. The detector 2 detects IR radiation 22 incident on it. It analyses the wavelength and intensity of the incident radiation. Its output will depend on the particular analysis required, however, it may include a time resolved spectrum. From this output, spectral components can be identified as corresponding to specific gases by referring to the wavelength components of the spectrum. The partial pressure of each gas is determined in accordance with the intensity of the relevant wavelength components. In order to calibrate the detector, a calibration signal 20, comprising an infrared beam which has not been passed through the measurement zone, is supplied from the source IRS to the detector 2. This may be achieved using, for example, an optical fibre or other optical transmitting device. For example, the signal 20 may be applied via free space, where the apparatus configuration allows. In a further embodiment, as also shown in figure 2 a control loop is used to provide a control signal to the radiation system LA to prevent the radiation system from providing a radiation beam PB in the case where a detected partial pressure of a contaminant gas exceeds a predetermined threshold. To this end, a control circuit 6 is coupled between the detector 2 and the radiation system LA. The control circuit 6 is responsive to the detector, and, arranged so that if the measured partial pressure of said contaminant exceeds a predetermined threshold, said control circuit generates a control signal to prevent the radiation system from providing said projection beam of radiation. The location of the source IRS and the detector 2 is not essential to the invention. In one embodiment, the source IRS and/or the detector 2 may be disposed within an evacuated region (as may be the case for example, in a lithographic apparatus operating in the EUV range) or, alternatively, the source IRS and/ or the detector 2 may be disposed outside the apparatus. In this alternative embodiment, windows, such as for example, calcium fluoride or quartz windows, are provided in the apparatus in order to allow the radiation to enter and leave the apparatus. In a further embodiment, independent of whether the detector is disposed within or outside the apparatus, in order to reduce noise levels in the detector 2, the detector may be cooled using for example, liquid nitrogen or a peltier element.

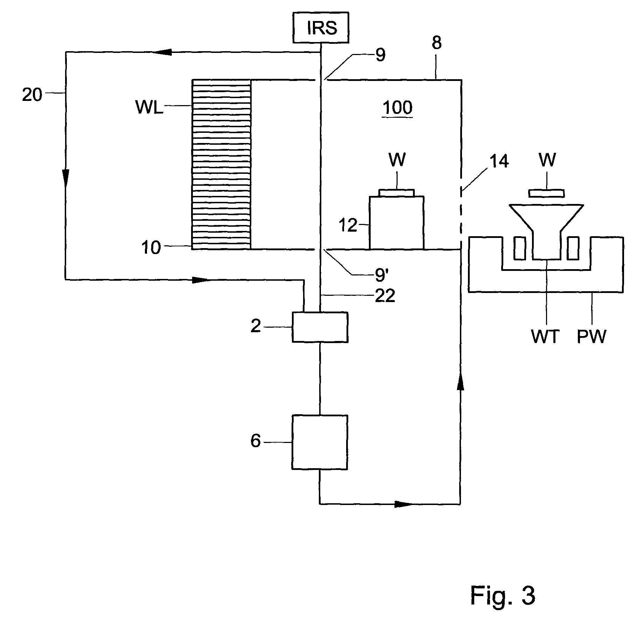

Figure 3 depicts details of a lithographic apparatus including an infrared absorption apparatus according to a further embodiment of the present invention. In the embodiment shown in figure 3, the same principles are applied as in the embodiment shown in figure 2. Reference is made to figure 2 for such principles. In addition, for those components depicted in figure 3 having the same reference numerals as components shown in figure 2, reference is also made to figure 2. Figure 3 shows a wafer (substrate) library WL including a substrate handling apparatus 12 for supplying a substrate W to wafer table WT. The wafer library WL includes a housing 8 in which a plurality of wafers 10 for exposure are stored prior to their exposure. The substrate handling apparatus 12 selects a wafer W from the library. The selected wafer W is then supplied via gate 14 to the wafer table WT. The gate 14 is generally kept closed during operation, and is only opened in order to allow a wafer W to be supplied to the wafer table WT. The infrared absorption IRS, 2, 100 is carried out using a source, as previously described. The IR radiation is provided into the measurement zone 100 via a window 9 provided in the housing 8. Having entered the measurement zone 100, the radiation exits the housing 8 via a window 9'. The windows 9,9' are preferably airtight, and comprise an IR transmissive material. As with the embodiment in shown in figure 2, although, the windows are shown to be aligned, this is not essential. In a further embodiment optical elements, such as reflectors and prisms (not shown) may be disposed in the housing in order to increase the path length along which the IR radiation passes. The detector 2, control loop including control circuit 6, detected beam 22 and calibration signal 20 function and serve the same purpose, respectively, as those similarly numbered components shown in figure 2, except that the control circuit, responsive to the detector 2, is arranged so that if the measured partial pressure of an contaminant exceeds a predetermined threshold, the control circuit generates a control signal to prevent the substrate handling apparatus 12 from supplying a substrate W to the substrate table WT. Alternatively, the similar arrangement of an IR source and a detector as shown in figure 3, may be adapted for use in a patterning means handling apparatus, such as a mask library. As far as contamination is concerned, the same applies to patterning means (masks) as applies to substrates (wafers). In particular, masks may also degas water or hydrocarbons depending on how they are stored or handled. Thus, the present invention also has application to mask libraries. In such an embodiment, the IR source is disposed to pass a beam of IR radiation through the mask library. The IR detector is disposed to receive radiation that has passed through the library. The detection is carried out as described with respect to the other embodiments.

Figure 4a depicts a plot of infrared intensity against wavelength of a calibration signal 20 for use in the detection according to an embodiment of the present invention and figure 4b depicts a plot of infrared intensity against wavelength of a detected signal 22 detected by detector 2 according to an embodiment of the present invention. The calibration signal 20 originates from the infrared source and represents the wavelength distribution of and respective intensities of the radiation emitted by the source. Although calibration signal 20 is depicted as a straight line, this is not necessarily the case, and the signal will vary depending on the particular source. The intensity of certain wavelengths may be higher or lower than other wavelengths. Further, as discussed below with reference figure 5, the source may be adapted to provide a range of specific wavelengths having a precisely defined wavelength and relatively high intensity. A calibration signal is provided to detector 2 for a representative plurality of the wavelengths emitted by the source. It is not necessary that a calibration signal 20 be provided for each wavelength emitted by the source. The detected beam 22 is that detected by the detector having passed through the measurement zone 1, 100. Depending on the gases present in the measurement zone, certain wavelength components of the infrared radiation are absorbed, this reduces the intensity of the detected beam at these particular wavelengths. In the example, shown in figure 4b, the absorbed wavelengths are those corresponding to troughs 24 and 26. The shape of the trough will vary depending of various factors. For example, at low pressure the width of the trough is narrower, and at higher temperatures the width of the trough is broader and the depth remains constant. These observations also follow Lambert Beer's law, discussed below.

The present invention may be used to detect a partial pressure of a gas in the lithographic apparatus. The partial pressures are detected to high degrees of accuracy. The pressure within a projection system in a lithographic apparatus operating in the EUV bandwidth is typically $10^{-3}$mbar. The partial pressure of contaminants such as water and a variety of hydrocarbons, are typically $10^{-7}$ and $10^{-9}$ mbar, respectively.

The relation between partial pressure and the absorption in the centre of the absorption lines 24, 26 is given by Lambert Beer's law:

$$I/I0 = exp(-a*1*p) \qquad \text{(equation 1)},$$

where 1 is the length of the path the infrared radiation passes through the measurement zone and p is the partial pressure to be measured. The constant a is the strength of the absorption line and depends on the gas that absorbs the radiation and on the particular line which is being observed. As mentioned, the width of the absorption line depends on the temperature of the absorbing gas, due to the Doppler effect, and on the total pressure. It is commented that even at 0 Kelvin at 0 Pascals pressure, the trough has a natural linewidth.

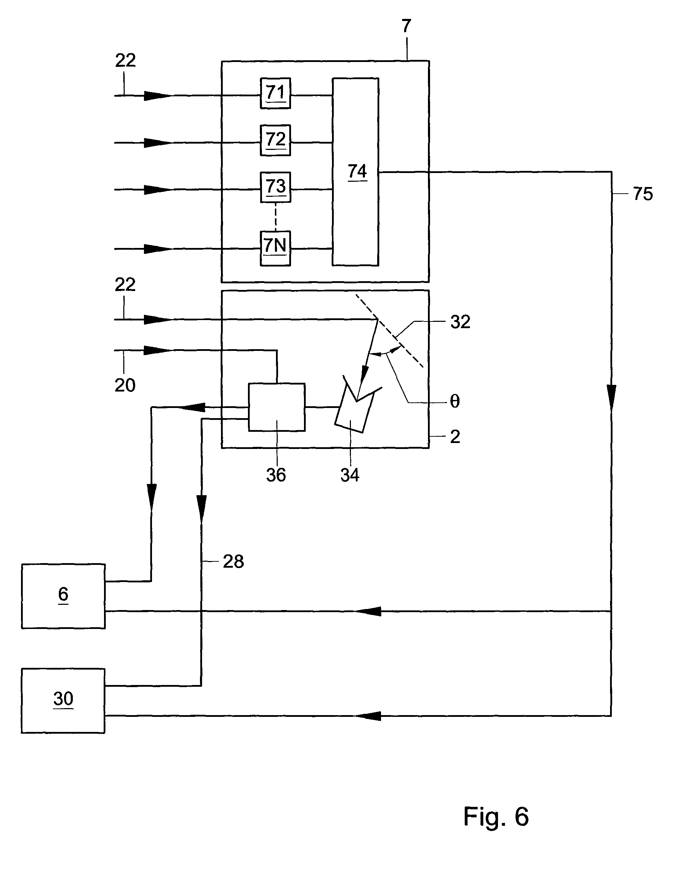

In addition, to measuring the partial pressure of a gas in the system, once a particular gas has been identified using the present invention, a data processor 36, refer to figure 6, may be used to further determine the temperature in the system and the total pressure in the system.

Figure 5 depicts details of an infrared source according to an embodiment of the present invention. In certain embodiments of the present invention the presence of particular gases is detected. For examples, some of the gases, in particular certain contaminants are to be closely monitored in the lithographic apparatus, as their presence can be highly damaging to apparatus components and the imaging process. In order to target specific gases the source is adapted accordingly. By adapting the source, the detection is highly selective and accurate. For such purposes a source has been developed. Such a source, as shown in figure 5, comprises at least one diode D1-DN. The or each diode is modulated to emit radiation 20, 22 of a particular wavelength. Depending on factors, such as the wavelength to be emitted, different diodes may comprise different semiconductor materials. The modulator 30 comprises at least one voltage source V1-VN which applies a voltage to the or each diode D1-DN, respectively. The modulator 30 controls the voltage applied to each diode in such a way that the radiation emitted by the diode or diodes has a wavelength which can be controlled to the order of picometres ($10^{-12}$m). This allows specific gases including contaminants to be directly targeted. If such an arrangement of diodes is used, and the path length in the measurement zone is arranged to be sufficiently long the detected signal 22 exhibits very strong absorption troughs, which allows properties such as the partial pressure to be determined accurately to an order of magnitude of $10^{-9}$ mbar, as is required by lithographic apparatuses operating in vacuum conditions. The diodes may be cooled.

In addition, or alternatively, the source may include a broadband radiation source. If it is uncertain which gases are present in the lithographic apparatus, a broad band infrared source is used. The detected signal 22 is then analyzed to determine the gases present in the apparatus on the basis of the absorption data contained in the detected signal. Once the presence of a particular gas has been confirmed, the modulator 30 tunes a diode to provide radiation having the appropriate wavelength in order to more accurately assess the partial pressure of the particular gas. If a gas is detected for the first time, this data gives insight into possible contamination processes that may occur in the lithographic apparatus. Further, a wavelength selector, such as a monochromator, may be provided to tune the wavelength of the source output by a diode or diodes for subsequent measurements at a particular wavelength to be carried out.

Figure 6 depicts details of an infrared detector according to an embodiment of the present invention. In a particular embodiment, a detector 2 receives the signal 22 to be detected. The calibration signal 20 is input directly to a data processing element 36. The calibration signal 20 is compared in the data processing element to the detected signal 22 to obtain an indication of the relative absorption of particular wavelengths. The signal to be detected is received by the detector 2. A detecting device 32, 34 such as a diffraction grating 32 and an angle and intensity measuring device 34 are arranged so that the signal to be detected is incident on the diffraction grating. In the embodiment shown, the diffraction grating is shown as a reflective grating, however, it may also be transmissive. By measuring the angle at which the signal is reflected by the grating, the wavelength of the light present in the detected signal is detected using Bragg's Law,

$$2dsin\ theta = m\ lambda \qquad \text{(equation 2)},$$

where d is the spacing between lines on the diffraction grating, theta is angle of reflection (or transmission if a transmission grating is used), and m is the order of the diffracted spectrum. The intensity of the signal is measured using a conventional intensity measuring circuit (not shown).

The data derived from the detected signal is provided to data processing element 36 which determines the gases present and other parameters such as its partial pressure, and the temperature and total pressure in the lithographic apparatus. In addition to providing a signal to the control circuit 6 described above, the data processing element 36 may also provide a signal 28 to the modulator 30 to cause the modulator to tune a diode or a plurality of diodes to a particular wavelength, as ascertained by the data processor corresponding to a wavelength absorbed (or scattered) by a particular gas to be targeted during further measurements. Optionally, a second detector 7 may also be provided. The purpose of the second detector is to provide a reference signal 75 which is fed to the control circuit 6 and the modulator 30. The reference signal 75 generated by the second detector 7 may also be used to calibrate the detector 2. The second detector 7 is arranged to receive the signal 22 to be detected and comprises at least one reference cell 71, 72, 73, 7N. The reference cells 71, 72, 73, 7N comprise closed chambers having IR transparent windows through which the signal 22 to be measured passes. The chambers are filled with known quantities of gases, such as water vapour. The reference cells may be filled with the same or differing gases. Whilst the second detector 7 may be disposed adjacent the first detector 2, this is not essential provided the second detector 7 is arranged to receive IR radiation that has passed through the measurement zone 1. In particular, when the second detector 75 are disposed outside the lithographic apparatus, the second detector can be used to ascertain in a fast manner the gases present. Also provided in the second detector 7 is a processing unit 74 which processes the output of the reference cells 71-7N.

Whilst specific embodiments of the invention have been described above, it will be appreciated that the invention may be practiced otherwise than as described. The description is not intended to limit the invention.

## Claims

1. A lithographic apparatus comprising:

   - an illumination system for providing a projection beam of radiation;
   - a support structure for supporting patterning means, the patterning means serving to impart the projection beam with a pattern in its cross-section;
   - a substrate table for holding a substrate; and
   - a projection system for projecting the patterned beam onto a target portion of the substrate,

   **characterized in that** said apparatus further comprises a source for providing infrared radiation into a measurement zone within said lithographic apparatus, and a detector for receiving said infrared radiation from said source after having passed through said measurement zone and for outputting a signal indicative of the presence of a gas present within said measurement zone.

2. A lithographic apparatus according to claim 1, wherein said source comprises a tunable infrared source, tuned so that the wavelength of the radiation output by said infrared source corresponds to the wavelength absorbed by at least one of a predetermined gas or gases.

3. A lithographic apparatus according to claim 2, wherein said source comprises a plurality of said tunable infrared sources, tuned to a plurality of wavelengths corresponding to a plurality of predetermined gases.

4. A lithographic apparatus according to any preceding claim, wherein said measurement zone is provided with at least one optical element which is disposed for causing said infrared radiation to follow a path having a path length longer than one of the dimensions of said measurement zone.

5. A lithographic apparatus according to any preceding claim, wherein said detector is arranged to detect the presence of a gas or gases in said projection system.

6. A lithographic apparatus according to claim 5, further comprising a control circuit, responsive to said detector, arranged so that if a measured partial pressure of said gas or at least one of said gases exceeds a predetermined threshold, said control circuit generates a control signal to prevent said illumination system from providing said projection beam of radiation.

7. A lithographic apparatus according to any of preceding claims 4-6, wherein said optical element or elements is comprised within said projection system.

8. A lithographic apparatus according to any of preceding claim 1-4, further comprising a substrate or patterning means handling apparatus for supplying a substrate to said substrate table or a patterning means to said support structure, respectively, wherein said detector is arranged to detect the presence of a gas or gases in said substrate or patterning means handling apparatus, respectively.

9. A lithographic apparatus according to claim 8, further comprising a control circuit, responsive to said detector, arranged so that if a measured partial pressure of said gas or at least one of said gases exceeds a predetermined threshold, said control circuit generates a control signal to prevent said substrate handling apparatus from supplying a substrate to said substrate table or said patterning means handling apparatus from supplying a patterning means to said support structure, respectively.

10. A lithographic apparatus according to any of preceding claims 1-5, 7 or 8, wherein said detector is arranged to measure the partial pressure/s of a contaminant gas or contaminant gases in said lithographic apparatus.

11. A device manufacturing method comprising the steps of:

- providing a substrate;
- providing a projection beam of radiation using an illumination system;
- using patterning means to impart the projection beam with a pattern in its cross-section; and
- projecting the patterned beam of radiation onto a target portion of the substrate,

**characterized by** providing infrared radiation into a measurement zone within said lithographic apparatus; receiving said infrared radiation after said infrared radiation has passed through said measurement zone; and outputting a signal indicative of the presence of a gas present within said measurement zone.

12. An infrared source for use in an infrared absorption apparatus for a lithographic apparatus according to any of preceding claims 1-10, comprising a tunable infrared source, tuned so that the wavelength of the radiation output by said infrared source corresponds to the wavelength absorbed by at least one of a predetermined or likely predetermined gas or gases.

13. An infrared source according to claim 12, wherein said infrared source comprises a plurality of said tunable infrared sources, tuned to a plurality of wavelengths corresponding to a plurality of predetermined or likely predetermined gases.

Fig. 1

Fig. 2

Fig. 3

Fig. 4a

Fig. 4b

Fig. 5

Fig. 6

**European Patent Office**

**EUROPEAN SEARCH REPORT**

Application Number

EP 04 07 7538

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 989 763 A (BENDIK JOSEPH ET AL) 23 November 1999 (1999-11-23) * column 3, line 35 – line 58 * * column 4, line 34 – column 6, line 38 * * figures 3,5 * | 1,2,5,8, 11-13 | G03F7/20 |
| X | EP 1 220 038 A (ASM LITHOGRAPHY BV) 3 July 2002 (2002-07-03) * paragraph '0037! – paragraph '0055! * * figure 2 * | 1,2,4-8, 10-12 | |
| A | PATENT ABSTRACTS OF JAPAN vol. 0132, no. 35 (E-766), 30 May 1989 (1989-05-30) & JP 1 041215 A (SHARP CORP), 13 February 1989 (1989-02-13) * abstract * | 1,11,12 | |
| D,A | US 3 939 348 A (BARRETT JOSEPH J) 17 February 1976 (1976-02-17) * column 3, line 23 – column 4, line 8 * * figure 1 * | 1,11,12 | TECHNICAL FIELDS SEARCHED (Int.Cl.7) G03F |

The present search report has been drawn up for all claims

| Place of search | Date of completion of the search | Examiner |
|---|---|---|
| The Hague | 8 October 2004 | Aguilar, M. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**                    EP 04 07 7538

This annex lists the patent family members relating to the patent documents cited in the above-mentioned European search report.
The members are as contained in the European Patent Office EDP file on
The European Patent Office is in no way liable for these particulars which are merely given for the purpose of information.

08-10-2004

| Patent document cited in search report | | Publication date | Patent family member(s) | | Publication date |
|---|---|---|---|---|---|
| US 5989763 | A | 23-11-1999 | NONE | | |
| EP 1220038 | A | 03-07-2002 | EP | 1220038 A1 | 03-07-2002 |
| | | | JP | 2002270501 A | 20-09-2002 |
| | | | TW | 556050 B | 01-10-2003 |
| | | | US | 2002134947 A1 | 26-09-2002 |
| JP 1041215 | A | 13-02-1989 | NONE | | |
| US 3939348 | A | 17-02-1976 | DE | 2525787 A1 | 01-04-1976 |
| | | | FR | 2274914 A1 | 09-01-1976 |
| | | | GB | 1510521 A | 10-05-1978 |
| | | | JP | 51011481 A | 29-01-1976 |
| | | | US | 4035643 A | 12-07-1977 |

EPO FORM P0459

For more details about this annex : see Official Journal of the European Patent Office, No. 12/82